# EUROPÄISCHE PATENTSCHRIFT

(11) **EP 2 133 998 B1**
(45) Veröffentlichungstag und Bekanntmachung des Hinweises auf die Patenterteilung: **20.11.2013**
(21) Anmeldenummer: 09160328.2
(22) Anmeldetag: 15.05.2009
(51) Int. Cl.: H03M 3/02, H03F 3/45

(54) **Digital-analog Wandler für pulsdichtemodulierte digitale Signale**
Digital-analogue converter for pulse density modulated digital signals
Convertisseur numérique-analogique pour signaux numériques modulés en densité d'impulsions

(30) Priorität: 11.06.2008 AT 9422008
(43) Veröffentlichungstag der Anmeldung: 16.12.2009
(73) Patentinhaber: Siemens Aktiengesellschaft, 80333 München (DE)
(72) Erfinder: Hörist, Gerald, 1220, Wien (AT)
(74) Vertreter: Maier, Daniel Oliver

(56) Entgegenhaltungen:
- EP-A2- 0 457 496
- ROBERT ADAMS ET AL: "A 113-dB SNR Oversampling DAC with Segmented Noise-Shaped Scrambling", IEEE JOURNAL OF SOLID-STATE CIRCUITS, IEEE SERVICE CENTER, PISCATAWAY, NJ, USA, vol. 33, no. 12, 1 December 1998 (1998-12-01), XP011060871, ISSN: 0018-9200

## Beschreibung

### Technisches Gebiet

Die Erfindung betrifft einen Digital-analog Wandler für pulsdichtemodulierte digitale Signale.

### Stand der Technik

Digital-analog Wandler (engl. digital-to-analog converter (DAC)), werden in einer Vielzahl von Anwendungen eingesetzt um digital repräsentierte Signale in Analogsignale umzusetzen. Je nach Einsatzzweck sind verschiedene Digital-analog Wandlungsverfahren im Einsatz, welche für den jeweiligen Einsatzzweck optimierbare Eigenschaften aufweisen.

Häufig werden sogenannte 1-Bit-Umsetzer Verfahren eingesetzt, welche als Pulsstrom vorliegende digitale Signale in entsprechende analoge Signale wandeln. Liegen digitale Signale in sogenannter Pulsdichtemodulation vor, so kann eine Digital-analog Wandlung besonders einfach erfolgen, da das analoge Signal einfach mittels Integration aus dem digitalen, pulsdichtemodulierten Datenstrom gewonnen werden kann (PDM Verfahren).

Pulsdichtemodulierte Signale beschreiben eine entsprechende analoge Signalform durch eine relative Dichte an digitalen Pulsen, wobei etwa im Gegensatz zu Pulsweitenmodulierten Signalen ein festes Zeitraster (Grundfrequenz) vorliegt welches die Zeitpunkte an denen das digitale Signal seinen Zustand (Null oder eins, bzw. "High" oder "low") wechseln kann vorgegeben sind.
Einem konstantem "High" Signal entspricht demnach die maximal mögliche analoge Ausgangsamplitude, einem konstantem "Low" Signal entspricht die minimal mögliche Ausgangsamplitude. Wechselt das digitale Signal zu jedem möglichen Zeitpunkt (im Zeitraster) die Polarität, so entspricht dieses Signal der mittleren möglichen analogen Ausgangsamplitude.

In praktischen Umsetzungen dieses Digital-analog Wandlungsverfahrens wird das digitale Signal einer sogenannten Treiberstufe zugeführt, und das Ausgangssignal tiefpaßgefiltert, wobei in praktischen Anwendung dazu meist eine sogenannte integrierte Operationsverstärkerschaltung eingesetzt wird. Da die Grundfrequenz von pulsdichtemodulierten Signalen üblicherweise hoch ist, (typischerweise 10MHz) wirken sich Unsymmetrien dieser Treiberstufe besonders nachteilig für die Genauigkeit dieser Digital-analog Wandler aus. Die Zeit, in welcher das Ausgangssignal der Treiberstufe von "High" auf "Low" wechselt ist im Allgemeinen unterschiedlich zu jener Zeit, in welcher Ausgangssignal der Treiberstufe von "Low" auf "High" wechselt. Dabei ist besonders nachteilig, dass der Fehler der Digital-analog Wandlung vom Wert des digitalen Eingangssignals bestimmt wird, wodurch im Gegensatz zu linearen Fehlern (z.B. Offsetfehler) fehlermindernde Gegenmaßnahmen wesentlich erschwert werden, da dieser (nichtlineare) Fehler zudem temperaturabhängig ist. Bespielsweise bewirkt bei einer maximalen Taktfrequenz des pulsdichtemodulierten Signals vom 10MHz (100ns Periodendauer) ein Unterschied zwischen Anstiegs- und Abfallzeit von Ins einen dadurch hervorgerufenen Wandlungsfehler von 1 Prozent.

Einen Digital-analog Wandler zeigt "A 113-dB SNR Oversampling DAC with segmented noise-shaped scrambling", Robert Adam et al, IEEE Journal of solid-state circuits, Bd.33, Nr.12, 1.Dez. 1998, XP011060871, ISSN: 0018-920. Dieser zeichnet sich durch einen hohen Störabstand aus, kann jedoch in vielen Einsatzgebieten nicht den erforderlichen Genauigkeits- und Linearitätsanforderungen genügen.

### Darstellung der Erfindung

Der Erfindung liegt daher die Aufgabe zugrunde, einen Digital-analog Wandler für pulsdichtemodulierte digitale Signale anzugeben, welche die Nachteile der Lösungen gemäß dem Stand der Technik nicht aufweist und insbesondere einen vom aktuellen Wert des zu wandelnden digitalen Signals unabhängigen Wandlungsfehler aufweist.

Die Aufgabe wird durch eine Schaltung mit den Merkmalen des Anspruchs 1 gelöst.

Dem Grundgedanken der Erfindung nach wird ein Digital-Analog Wandler für pulsdichtemodulierte digitale Signale mit einem aus einem Operationsverstärker-Differenzverstärker aufgebauten Integrator beschrieben, welcher im Signalweg zum invertierenden Eingang des Operationsverstärkers eine invertierende Treiberstufe vorsieht und im Signalweg zum nichtinvertierenden Eingang des Operationsverstärkers eine nichtinvertierende Treiberstufe vorsieht.

Dadurch ist der Vorteil erzielbar, dass unvermeidliche Anstiegs- und Abfallzeiten der Ausgangssignale der Treiberstufen keinen Fehler der Digital-analog Wandlung hervorrufen können, da ein erfindungsgemäßer Digital-analogwandler zur Tiefpassfilterung des zu wandelnden pulsdichtemodulierten digitalen Signals einen Differenzverstärker einsetzt und die unterschiedlichen Anstiegs- und Abfallzeiten der Ausgangssignale der Treiberstufen dadurch kompensiert werden.

Eine wesentliche Eigenschaft der erfindungsgemäßen Schaltung liegt in der Umsetzbarkeit mittels preisgünstiger Bauteile, welche keine besonders hohen Anforderungen an deren elektrische Eigenschaften erfüllen müssen. Insbesonders ist es nicht erforderlich, die Treiberstufen durch Bauteile zu realisieren, welche besonders geringe Anstiegs- und Abfallzeiten der Ausgangssignale aufweisen.

Der Hauptaspekt der erfindungsgemäß vorgeschlagenen Lösung liegt darin, dass durch die erfindungsgemäße Schaltung eine Fehlerquelle beseitigt wird, die durch andere Maßnahmen nicht, bzw, nur mit sehr hohem Aufwand beseitigt werden kann. Der Verlauf des Fehlers, welcher durch die unterschiedliche Anstiegs- und Abfallzeiten der Ausgangssignale der Treiberstufen hervorgerufen wird, ist über den gesamten Aussteuerbereich der pulsdichtemodulierten digitalen Signals nichtlinear und besitzt ein Maximum bei einer Aussteuerung von 50 Prozent.

Eine bevorzugte Ausführungsform der Erfindung sieht vor, die Treiberstufen mittels integrierter Schaltungen aufzubauen, wobei einfache und preisgünstige integrierte Schaltungen für den Aufbau eines erfindungsgemäßen Digital-analogwandler ausreichend sind, sofern die solcherart aufgebauten Treiberstufen ausreichend elektrische Leistung an den Differenzverstärker abgeben können.

Eine zweckmäßige Weiterbildung der Erfindung sieht vor, die Treiberstufen mit einem Schaltsignal auszustatten, womit es ermöglicht wird, den Digital-analogwandler ein- und auszuschalten. Dazu werden die Treiberstufen mittels zweier sogenannter XOR-Gatter realisiert und das zu wandelnde pulsdichtemodulierte digitale Signal an jeweils einen Eingang beider XOR-Gatter geleitet. Der weitere Eingang ersten der XOR-Gatter wird konstant mit logischem "High" Pegel beaufschlagt, der weitere Eingang des zweiten XOR-Gatters bildet den Schalteingang. Ist der logische Pegel des an diesen Schalteingang geführten Schaltsignals "High", so wirken beide XOR-Gatter als logische Inverter und geben synchron an ihren Ausgängen ein invertiertes Abbild des pulsdichtemodulierten digitalen Signals ab und der Differenzverstärker wird an beiden seiner Eingänge mit dem gleichen Signal beaufschlagt und das Ausgangssignal des Differenzverstärkers nimmt jenen Wert an, welcher bei Betrieb des Digital-analogwandlers bei einem pulsdichtemodulierten Signal mit einem Wert der Aussteuerungvon 50 Prozent erhalten wird.

Ist der logische Pegel des an diesen Schalteingang geführten Schaltsignals "low", so wirkt das zweite XOR-Gatter als logischer Puffer und gibt das pulsdichtemodulierte digitale Signal an seinem Ausgang unverändert ab und die Funktion des Digital-analogwandlers ist hergestellt.

Diese Schaltfunktion ist besonders vorteilhaft für alle Anwendungen, in welchen der Digital-analog Wandler beispielsweise bei fehlendem oder unzuverlässigem Eingangssignal, etwa während der Startphase eines dieses Eingangssignals erzeugenden Mikrokontrollers, keine zufälligen analogen Ausgangssignale abgeben darf.

### Kurzheschreibung der Zeichnungen

Es zeigen beispielhaft:
**Fig. 1** die Darstellung des prinzipiellen Aufbaus eines Digital-analog Wandlers für pulsdichtemodulierte digitale Signale gemäß dem Stand der Technik.
**Fig. 2** die Darstellung des zeitlichen Verlaufs des digitalen Eingangssignals mit unterschiedlichen Anstiegs- und Abfallzeiten.
**Fig. 3** die Darstellung des Fehlerverlaufs über die Aussteuerung des pulsdichtemodulierten digitalen Signals.
**Fig. 4** die Darstellung des prinzipiellen Aufbaus eines erfindungsgemäßen Digital-analog Wandlers für pulsdichtemodulierte digitale Signale.
**Fig. 5** die Darstellung des prinzipiellen Aufbaus einer weiteren Ausführungsform eines erfindungsgemäßen Digital-analog Wandlers für pulsdichtemodulierte digitale Signale mit Schalteingang.

### Ausführung der Erfindung

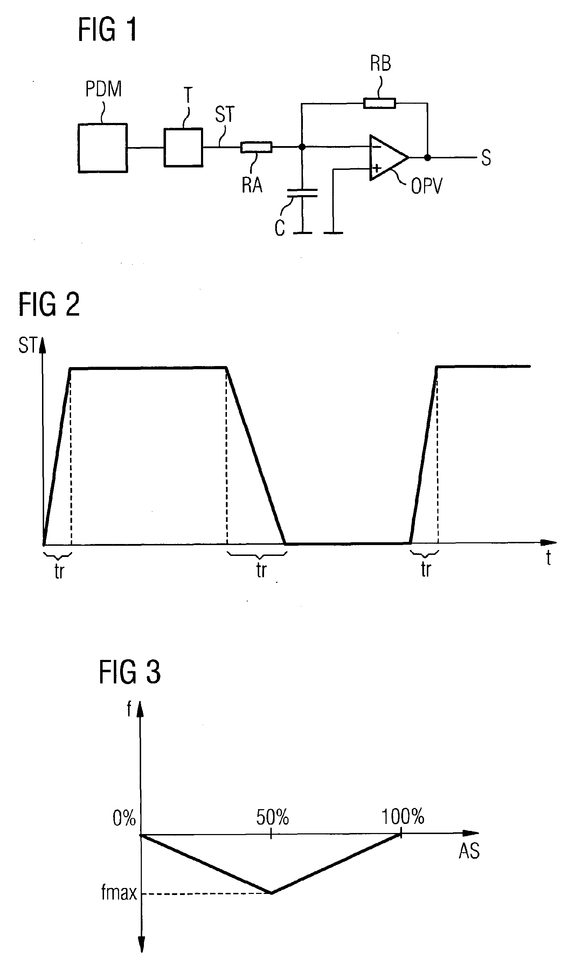

**Fig. 1** zeigt beispielhaft und schematisch den prinzipiellen Aufbau eines Digital-analog Wandlers für pulsdichtemodulierte digitale Signale gemäß dem Stand der Technik. Das zu wandelnde pulsdichtemodulierte Signal PDM wird einem Treiber T zugeführt, welcher den zeitlichen Verlauf des pulsdichtemodulierten Signals PDM unverändert lässt, jedoch die Entnahme elektrischer Leistung aus dem Ausgangssignal ST des Treibers ermöglicht. Dieses Ausgangssignal ST des Treibers wird einer Operationsverstärkerschaltung, bestehend aus einem Operationsverstärker OPV, einem Widerstand RA, einem Widerstand RB und einem Kondensator C, welche in sogenannter Tiefpaßschaltung verbunden sind, zugeführt. Mittels geeigneter Dimensionierung der Widerstände RA, RB und des Kondensators C werden die Spannungsverstärkung und die Grenzfrequenz dieser Tiefpaßschaltung festgelegt und an die jeweiligen Anforderungen angepasst. Das analoge Ausgangssignal S stellt das analoge äquivalent des digitalen pulsdichtemodulierten Signals PDM dar.

**Fig.2** zeigt beispielhaft und schematisch die Darstellung des zeitlichen Verlaufs des Ausgangssignal ST des Treibers mit unterschiedlichen Anstiegs- und Abfallzeiten. Es ist der zeitliche Verlauf eines digitalen Signals dargestellt, welches zwischen einem minimalen Wert und einem maximalen Wert wechselt, die waagrechte Achse stellt die Zeit t dar. Das Ausgangssignal ST des Treibers ist im Fall der halben Aussteuerung AS der pulsdichtemodulierten Signals PDM dargestellt, wobei unterschiedliche Zeiten für den Anstieg des Signals vom minimalen Wert auf den maximalen Wert (Anstiegszeit tr) und für den Abfall des Signals vom maximalen Wert auf den minimalen Wert (Abfallzeit tf) vorliegen. Der minimale Wert kann Null betragen, dies ist für die gegenständliche Erfindung jedoch nicht bedeutsam.

**Fig.3** zeigt beispielhaft die Darstellung des Fehlerverlaufs über die Aussteuerung des digitalen Signals. Die Digital-analog Wandlerschaltung, welche unterschiedliche Anstiegszeiten tr und Abfallzeiten tf aufweist, wird zur Darstellung des Wandlungsfehlers in Abhängigkeit von der Aussteuerung AS frei von anderen Fehlerquellen gedacht. Die senkrechte Achse stellt den Wert des Fehlers f in Prozent des maximalen analogen Ausgangswerts dar, die waagrechte Achse stellt die Aussteuerung AS des pulsdichtemodulierten Signals PDM in Prozent dar. Einer Aussteuerung AS von Null Prozent entspricht ein pulsdichtemoduliertes Signal PDM mit konstantem minimalem Wert, einer Aussteuerung AS von hundert Prozent entspricht ein pulsdichtemoduliertes Signal PDM mit konstantem maximalem Wert. Diese beiden Extremwerte bedingen, da das pulsdichtemodulierte Signal PDM in beiden Fällen niemals seinen Wert ändert, einen Fehler f von Null Prozent da eventuelle Anstiegszeiten tr oder Abfallzeiten tf niemals auftreten und somit keinen Fehler verursachen können. Beträgt die Aussteuerung AS fünfzig Prozent, so entspricht dies einem pulsdichtemodulierten Signal PDM, welches mit der größtmöglichen Frequenz seinen Wert zwischen einem minimalen und einem maximalen Wert wechselt. In diesem Fall wirken sich Differenzen zwischen der Abfallzeit tf und der Anstiegszeit tr auf den Fehler f der Digital-analog Wandlerschaltung maximal aus und der Fehler f nimmt einen Maximalwert fmax an. In Fig.3 ist beispielhaft ein maximaler Fehler fmax mit negativem Wert dargestellt. Für alle anderen Werte der Aussteuerung AS liegt der Wert des Fehlers f unterhalb des bei einer Aussteuerung von fünfzig Prozent auftretenden Fehlermaximums.

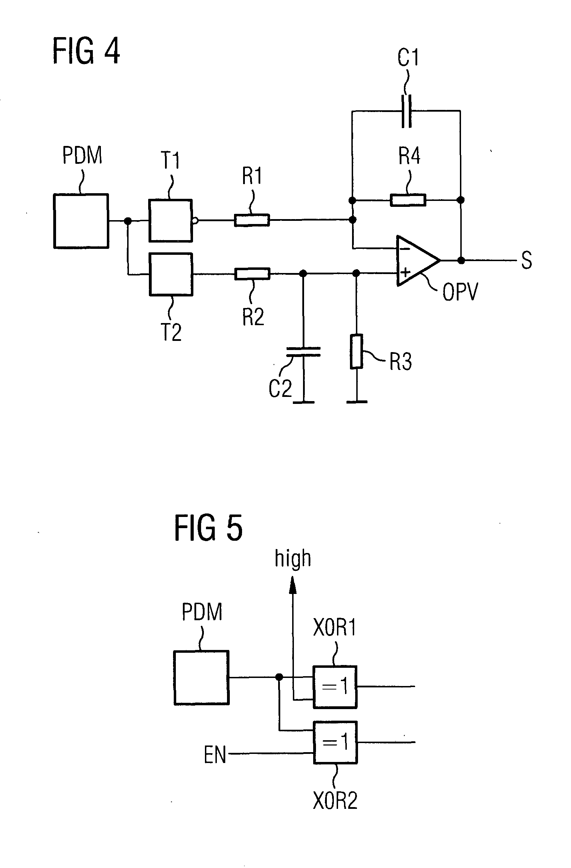

**Fig.4** zeigt beispielhaft und schematisch die Darstellung des prinzipiellen Aufbaus eines erfindungsgemäßen Digital-analog Wandlers für pulsdichtemodulierte digitale Signale. Das zu wandelnde pulsdichtemodulierte Signal PDM wird erfindungsgemäß gleichzeitig zwei Treibern zugeführt, wobei ein Treiber T1 das pulsdichtemodulierte Signal PDM invertiert und der andere Treiber T2 das pulsdichtemodulierte Signal PDM nicht invertiert. Die Ausgangssignale der beiden Treiber T1, T2 werden einer sogenannten Differenzverstärkerschaltung, umfassend einen Operationsverstärker OPV, den Widerständen R1, R2, R3, R3 und den Kondensatoren C1, C2 zugeführt. Das Ausgangssignal des invertierenden Treibers T1 wird über den Widerstand R1 dem invertierenden Eingang des Operationsverstärkers OPV zugeführt, das Ausgangssignal des nichtinvertierenden Treibers T2 wird über den Widerstand R2 dem nichtinvertierenden Eingang des Operationsverstärkers OPV zugeführt. Das analoge Ausgangssignal S stellt das analoge äquivalent des digitalen pulsdichtemodulierten Signals PDM dar. Durch die erfindungsgemäße Schaltung wird der durch unterschiedliche Anstiegszeiten tr und Abfallzeiten tf hervorgerufene Fehler kompensiert.

**Fig.5** zeigt beispielhaft und schematisch die Darstellung des prinzipiellen Aufbaus einer weiteren Ausführungsform eines erfindungsgemäßen Digital-analog Wandlers für pulsdichtemodulierte digitale Signale mit Schalteingang. Es ist ein pulsdichtemoduliertes Signal PDM dargestellt, welches an jeweils einen Eingang von zwei XOR-Gattern XOR1, XOR2 geführt wird. Der zweite Eingang des ersten XOR-Gatters XOR1 ist konstant mit dem logischen high Pegel verbunden. Der zweite Eingang des zweiten XOR-Gatters XOR2 ist mit einem Schaltsignal EN belegt. Die weiteren Bestandteile der erfindungsgemäßen Digital-Analogwandlerschaltung entsprechen dem in Fig. 4 dargestellten und sind in Fig.5 zur Vereinfachung nicht dargestellt.

Die beiden XOR-Gatter XOR1, XOR2 erfüllen die Aufgabe der Treiber wie in Fig.4 dargestellt. Das erste XOR-Gatter XOR1 wirkt in dieser Schaltung als Inverter und gibt an seinem Ausgang das invertierte Eingangssignal des einen Eingangs, welcher das pulsdichtemodulierte Signal PDM empfängt, aus. Das zweite XOR-Gatter wirkt in dieser Schaltung als Inverter, welcher von dem Schaltsignal EN in einen Puffer umschaltbar ist, wobei bei einem Schaltsignal EN mit logischem High Pegel das zweite XOR-Gatter XOR2 dieselbe Funktion wie das erste XOR-Gatter XOR1 aufweist und das Eingangssignal (pulsdichtemoduliertes Signal PDM) invertiert. Bei einem Schaltsignal EN mit logischem low Pegel gibt das zweite XOR-Gatter XOR2 das Eingangssignal (pulsdichtemoduliertes Signal PDM) unverändert als Ausgangssignal aus und wirkt somit als Puffer. Die (in Fig.5 nicht dargestellte) Differenzverstärkerschaltung kann somit bei einem Schaltsignal EN mit logischem high Pegel und somit identischen Ausgangssignalen der beiden XOR-Gattern XOR1, XOR2 keine Differenz zwischen diesen Ausgangssignalen verarbeiten und es stellt sich als Ausgangsspannung S jener Wert ein, welcher bei einem Schaltsignal EN mit logischem low Pegel und einem pulsdichtemodulierten Signal PDM mit einem Wert der Aussteuerung AS von 50 Prozent erhalten wird.

### Liste der Bezeichnungen

- PDM: Pulsdichtemoduliertes Signal
- T: Treiber
- RA, RB: Widerstände
- C: Kondensator
- ST: Ausgangssignal des Treibers
- OPV: Operationsverstärker
- t: Zeit
- tr: Anstiegszeit
- tf: Abfallzeit
- f: Fehler
- fmax: maximaler Fehler
- AS: Aussteuerung
- T1: invertierender Treiber
- T2: nichtinvertierender Treiber
- R1, R2, R3, R4: Widerstände
- C1,C2: Kondensatoren
- S: analoges Ausgangssignal
- XOR1,2: XOR Gatter
- EN: Schaltsignal
- High: logisches high Signal

## Patentansprüche

1. Digital-Analog Wandler für pulsdichtemodulierte digitale Signale (PDM) mit einem aus einem Operationsverstärker-Differenzverstärker aufgebauten Integrator **dadurch gekennzeichnet, dass** im Signalweg zum invertierenden Eingang des Operationsverstärkers (OPV) eine invertierende Treiberstufe (T1) vorgesehen ist und im Signalweg zum nichtinvertierenden Eingang des Operationsverstärkers (OPV) eine nichtinvertierende Treiberstufe (T2) vorgesehen ist und wobei die Treiberstufen (T1, T2) mittels logischer XOR-Gatter (XOR1, XOR2) aufgebaut sind und das pulsdichtemodulierte digitale Signal (PDM) an jeweils einem Eingang jedes der beiden XOR-Gatter (XOR1, XOR2) anliegt und der zweite Eingang des ersten XOR-Gatters (XOR1) mit logischem high-Pegel beaufschlagt ist und ein Schaltsignal (EN) an den zweiten Eingang des zweiten XOR-Gatter (XOR2) geführt ist.

2. Digital-Analog Wandler für pulsdichtemodulierte digitale Signale gemäß Anspruch 1 **dadurch gekennzeichnet, dass** die Treiberstufen (T1, T1) als mittels integrierter Schaltungen aufgebaute logische Gatter realisiert sind.

## Claims

1. Digital-analogue converter for pulse density modulated digital signals (PDM) having an integrator constructed from an operational amplifier-differential amplifier, **characterised in that** an inverting driver stage (T1) is provided in the signal path to the inverting input of the operational amplifier (OPV) and a non-inverting driver stage (T2) is provided in the signal path to the non-inverting input of the operational amplifier (OPV) and wherein the driver stages (T1, T2) are constructed by means of logical XOR gates (XOR1, XOR2) and the pulse density modulated digital signal (PDM) is present at each input of each of the two XOR gates (XOR1, XOR2) and the second input of the first XOR gate (XOR1) is exposed to the logical high level and a switching signal (EN) is fed to the second input of the second XOR gate (XOR2).

2. Digital-analogue converter for pulse density modulated digital signals according to claim 1, **characterised in that** the driver stages (T1, T1) are realised as logical gates constructed using integrated circuits.

## Revendications

1. Convertisseur numérique-analogique pour signaux numériques modulés en densité d'impulsions (PDM), comportant un intégrateur réalisé à partir d'un amplificateur différentiel - amplificateur opérationnel, **caractérisé en ce qu'**un étage pilote inverseur (T1) est prévu dans le chemin des signaux vers l'entrée inverseuse de l'amplificateur opérationnel (OPV) et **en ce qu'**un étage pilote non inverseur (T2) est prévu dans le chemin des signaux vers l'entrée non inverseuse de l'amplificateur opérationnel (OPV), les étages pilotes (T1, T2) étant réalisés au moyen de portes logiques XOR (XOR1, XOR2) et le signal numérique modulé en densité d'impulsions (PDM) étant appliqué à respectivement une entrée de chacune des deux portes XOR (XOR1, XOR2) et la deuxième entrée de la première porte XOR (XOR1) étant soumise à un niveau logique haut et un signal de commutation (EN) étant envoyé sur la deuxième entrée de la deuxième porte XOR (XOR2).

2. Convertisseur numérique-analogique pour signaux numériques modulés en densité d'impulsions selon la revendication 1, **caractérisé en ce que** les étages pilotes (T1, T1) se présentent sous la forme de portes logiques réalisées au moyen de circuits intégrés.
